# EUROPEAN PATENT APPLICATION

(11) **EP 4 546 402 A1**
(43) Date of publication of application: **30.04.2025**
(21) Application number: 22949514.8
(22) Date of filing: 28.06.2022
(51) Int. Cl.: H01L 21/67, H01L 21/683, H01L 21/687, H01L 21/68

(54) **MICRO-LED DISPLAY MANUFACTURING DEVICE**

(71) Applicant: LG Electronics Inc., Yeongdeungpo-gu Seoul 07336 (KR)
(72) Inventor: KIM, Seohyeon, Seoul 06772 (KR); KIM, Youngkyu, Seoul 06772 (KR); LEE, Hyounjoo, Seoul 06772 (KR); LEE, Munsu, Seoul 06772 (KR)
(74) Representative: Vossius & Partner Patentanwälte Rechtsanwälte mbB
(86) International application number: PCT/KR2022/009261
(87) International publication number: WO 2024/005221

(57) **Abstract**

The present embodiment comprises: a substrate chuck on which a substrate is seated; a transfer head having a suction plate to which donor is suctioned and transferring an LED-chip having been transferred to the donor onto the substrate; and a vision sensor disposed under the substrate chuck, wherein a light source for emitting light toward the donor is disposed on the suction plate.

## Description

### [Technical Field]

The present disclosure relates to an apparatus for manufacturing a micro-LED display.

### [Background Art]

Recently, display devices with good characteristics such as thinness and flexibility are being developed in the display technology field. The major displays currently commercialized are represented by LCD (Liquid Crystal Display) and AMOLED (Active Matrix Organic Light Emitting Diodes).

However, LCD has problems such as slow response time and difficulty in implementing flexibility, and AMOLED has vulnerabilities such as short lifespan and poor mass production yield.

Meanwhile, light-emitting diodes (LEDs) are well-known semiconductor light-emitting elements that convert current into light. Starting with the commercialization of red LEDs using GaAsP compound semiconductors, they have been used as light sources for display images in electronic devices including information and communication devices along with green LEDs of the GaP:N series. Therefore, a method can be proposed to solve the above problems by implementing a display (i.e., LED display) using the above semiconductor light-emitting elements. These light-emitting diodes have various advantages compared to filament-based light-emitting devices, such as long life, low power consumption, excellent initial driving characteristics, and high vibration resistance.

Meanwhile, micro-LEDs (µLEDs) with a size of 10 to 100 micrometers (µm), which are 1/10th the length and 1/100th the area of general light-emitting diode (LED) chips, are gradually increasing.

These micro-LEDs (µLEDs) have the advantages of faster response speed, lower power, higher brightness, and not breaking when applied to displays when bent, compared to conventional LEDs.

A display device using the micro-LED (µLED) can perform an LED chip transfer process in which an LED chip is provided to a donor and then the LED chip provided to the donor is transferred back to a substrate.

After the LED chip transfer process is completed, a donor stripping process in which the donor is removed from the substrate can be performed.

### [Invention]

### [Technical Problem]

The present embodiment provides a micro-LED display manufacturing device in which a vision sensor can simultaneously photograph a substrate and a donor, and the substrate and the donor can be aligned together.

### [Technical Solution]

An apparatus for manufacturing a micro-LED display according to an aspect of embodiments may include a substrate chuck on which a substrate is mounted; a transfer head having an adsorption plate on which a donor is adsorbed, transferring an LED chip transferred to the donor to the substrate; and a vision sensor disposed below the substrate chuck, wherein a light source irradiating light toward the donor is disposed on the adsorption plate.

The substrate chuck may include a panel chuck having a plurality of suction holes formed therein; a pin disposed to be liftable on the panel chuck and lifting the substrate; and a plurality of aligners for aligning the substrate.

The panel chuck may be disposed above the vision sensor, and the panel chuck may be made of a Pyrex material.

The pin may have a curved upper surface.

The plurality of aligners may include a left aligner and a right aligner spaced apart in a left-right direction; and a front-side aligner and a right-side aligner spaced apart in a front-back direction.

The aligner may include a urethane roller; a link on which the urethane roller is arranged; and a motor for driving the link.

The suction plate may be formed with a light source receiving portion into which the light source is inserted and received.

The suction plate may include a suction plate having a plurality of suction holes and in which the light source receiving portion is formed spaced apart from the suction hole; and a fixing plate arranged on the upper surface of the suction plate and covering the light source receiving portion.

The transfer head may further include a driving module; a connecting bracket connected to the driving module and having a lower portion connected to the suction plate; a lifting plate arranged on the upper portion of the driving module; and a lifting mechanism for lifting the lifting plate.

The driving module may have an X-axis driving source, a Y-axis driving source, a Θ-axis driving source, a Tx-axis driving source, and a Ty-axis driving source, and is a 5-axis module that moves the connecting bracket along the X-axis and Y-axis and rotates connecting bracket along the Tx-axis, Ty-axis, and Θ-axis.

The transfer head may further include a displacement sensor for calculating a height or inclination between the substrate and the donor.

A gap may be formed between the suction plate and the driving module, and the displacement sensor is received in the gap.

### [Effect of the Invention]

According to this embodiment, a light source installed on the suction plate can backlight the donor absorbed by the suction plate, and a vision sensor on the lower side of the substrate can reliably recognize the align key of the substrate and the align key of the donor at the same time.

In addition, since the light source is placed on the suction plate, inspection and repair of the light source are easy.

In addition, since the panel chuck is made of Pyrex material, the reliability of the vision sensor can be high.

In addition, since the upper part of the pin is curved, the contact area between the substrate and the pin can be minimized.

In addition, since the substrate chuck includes a plurality of aligners that align the substrate, the substrate and the donor can be aligned at the same time, and the plurality of aligners can correct the alignment key of the substrate and the alignment key of the donor at the same time.

In addition, since the aligner includes a urethane roller made of urethane material, damage to the substrate caused by the aligner can be minimized. In addition, the light source is inserted and received in the light source receiving portion formed on the suction plate, and when the light source protrudes, the light source can be protected more reliably.

In addition, the light source received in the suction plate can be protected by the fixing plate, and the light from the light source can be reliably irradiated to the donor.

In addition, since the displacement sensor is received in the gap between the suction plate and the driving module, damage to the displacement sensor can be minimized.

### [Description of Drawings]

FIG. 1 is a perspective view of an apparatus for manufacturing a micro-LED display according to the present embodiment.
FIG. 2 is a plan view of an apparatus for manufacturing a micro-LED display according to the present embodiment.
FIG. 3 is a diagram illustrating a transfer process by an apparatus for manufacturing a micro-LED display according to the present embodiment.
FIG. 4 is a perspective view of a panel stage according to the present embodiment.
FIG. 5 is a perspective view of a panel pop-up mechanism according to the present embodiment.
FIG. 6 is a front view of the panel pop-up mechanism according to the present embodiment when the substrate is bent.
FIG. 7 is a perspective view of an aligner according to the present embodiment.
FIG. 8 is a perspective view illustrating a panel vision alignment mechanism according to the present embodiment.
FIG. 9 is a perspective view of a transfer head according to the present embodiment.
FIG. 10 is a perspective view illustrating an adsorption plate of a transfer head according to the present embodiment.
FIG. 11 is a perspective view illustrating an adsorption plate and a light source of a transfer head according to the present embodiment.
FIG. 12 is a perspective view illustrating a drive module of a transfer head according to the present embodiment.
FIG. 13 is a perspective view illustrating a lifting mechanism of a transfer head according to the present embodiment.

### [Best Mode]

Hereinafter, specific embodiments of the present disclosure will be described in detail with drawings.

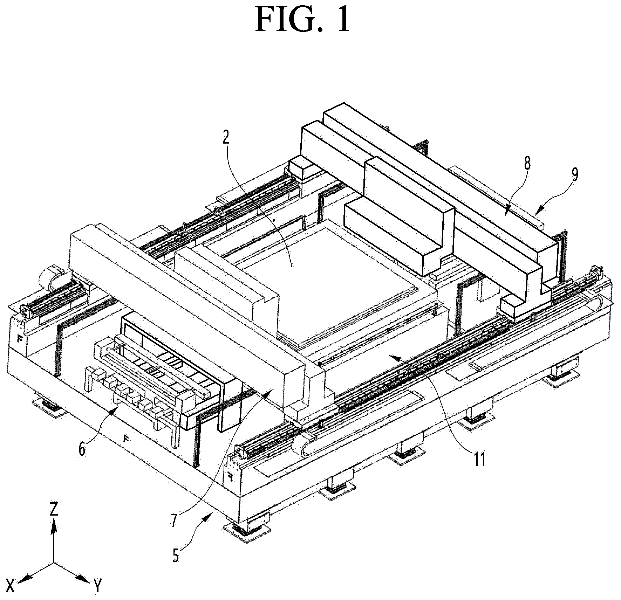

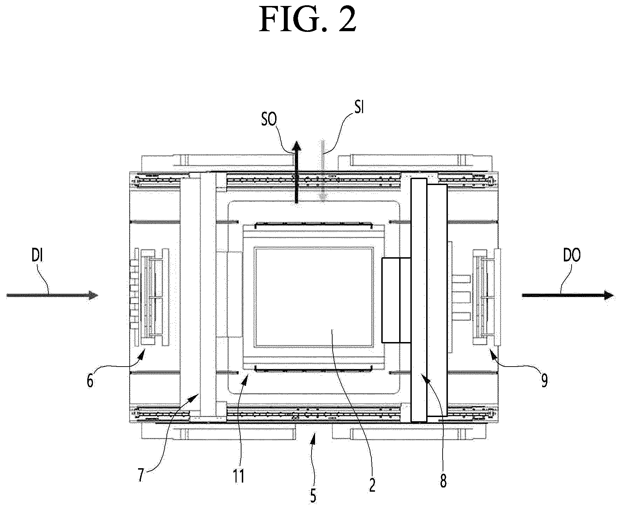

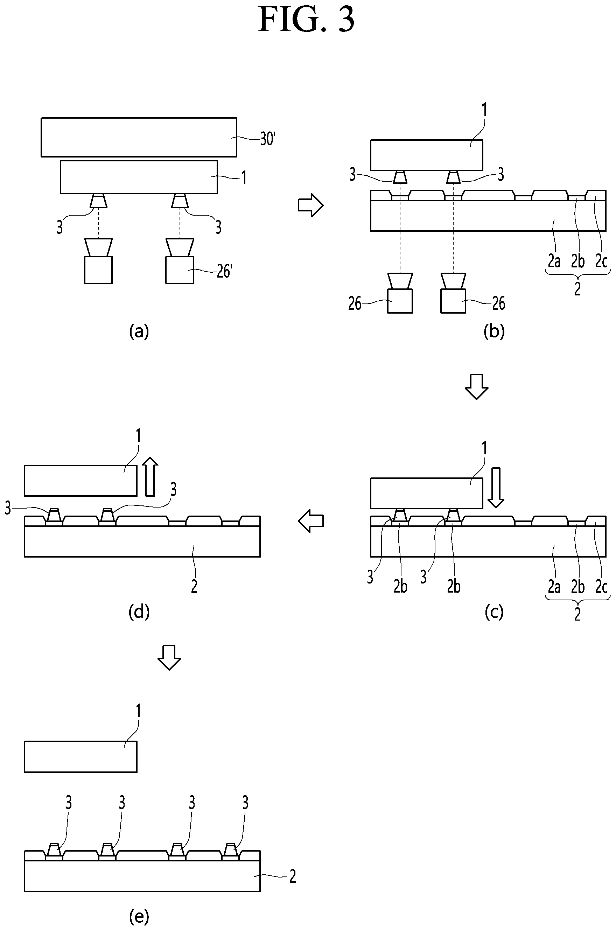

FIG. 1 is a perspective view of an apparatus for manufacturing a micro-LED display according to the present embodiment, FIG. 2 is a plan view of an apparatus for manufacturing a micro-LED display according to the present embodiment, and FIG. 3 is a diagram illustrating a transfer process by an apparatus for manufacturing a micro-LED display according to the present embodiment.

The apparatus for manufacturing a micro-LED display may transfer an LED chip 3 provided to a donor (1, see FIG. 3) to a substrate 2. The apparatus for manufacturing a micro-LED display may be a transfer device that transfers the LED chip 3 to the substrate 2.

The apparatus for manufacturing a micro-LED display may include a panel stage 5, a donor loader 6, a transfer head 7, a detaching head 8, and a donor unloader 9, as shown in FIGS. 1 and 2.

The donor 1 may be an interposer provided with an LED chip 3 on one side. The donor 1 may be loaded onto the substrate 2 to transfer the LED chip 3 onto the substrate 2. The donor 1 is preferably formed of a transparent material or a translucent material.

The donor 1 may be provided with an align key, and may be loaded into the apparatus for manufacturing a micro-LED display while the align key is provided.

The drawing symbol DI illustrated in FIG. 2 indicates a direction in which the donor 1 is loaded onto the substrate 2, and the drawing symbol DO illustrated in FIG. 2 indicates a direction in which the donor 1 is unloaded from the substrate 2.

The substrate 2 may be mounted on the panel stage 5, as illustrated in FIGS. 1 and 2.

An example of the substrate 2 may include a panel 2a and an adhesive 2b formed on an upper surface of the panel 2a, as shown in FIG. 3.

An example of the panel 2a may be a CID panel. The material of the panel 2a may be a glass material. It is preferable that the panel 2a is formed of a transparent material or a translucent material.

A plurality of adhesives 2b may be formed on the upper surface of the panel 2a, and the plurality of adhesives 2b may be separated from each other.

Among the substrates 2, the panel 2a may be mounted on the panel stage 5, and the panel 2a may be chucked to the panel stage 5.

An example of the substrate 2 may further include a light guide 2c. The light guide 2c may be a partition wall that partitions the LED chip 3. The light guide 2c may be a reflective layer or reflective sheet that reflects the light of the LED chip 3.

When the substrate 2 is mounted on the panel stage 5, the light guide 2c may be formed in a plurality of numbers on the upper surface of the panel 2a, and the plurality of adhesives 2b may be spaced apart from each other by the light guide 2c. When a plurality of LED chips 3 is transferred to the substrate 2, the light guide 2c may be positioned between the multiple LED chips 3.

An align key may be provided on the substrate 2, and the substrate may be loaded onto the panel stage 5 while the align key is provided.

The drawing symbol SI illustrated in FIG. 2 indicates the direction in which the substrate 2 is loaded onto the panel stage 5, and the drawing symbol SO illustrated in FIG. 2 indicates the direction in which the substrate 2 is unloaded on the panel stage 5.

The substrate 2 may be advanced in the front-back direction Y above the panel stage 5 as shown in FIG. 2, and may be retracted in the front-back direction Y above the panel stage 5.

A plurality of LED chips 3 may be provided on the donor 1. The LED chip 3 provided on the donor 1 may be a micro-LED chip, and a plurality of micro-LED chips may be provided on one surface of the donor 1. The LED chips 3 may be loaded into the apparatus for manufacturing a micro-LED display while being provided on the bottom surface of the donor 1.

Hereinafter, the configuration of the apparatus for manufacturing a micro-LED display will be described.

The panel stage 5 may include a substrate chuck 11 on which the substrate 2 is mounted.

The substrate chuck 11 may be positioned between the donor loader 6 and the donor unloader 9 in the left-right direction X, and may horizontally chuck the substrate 2. As shown in FIGS. 1 and 2, the substrate 2 may receive the LED chip 3 from the donor 1 while being placed on the substrate chuck 11.

The panel stage 5 may align the position of the substrate 2. The panel stage 5 may simultaneously align the substrate 2 and the donor 1. The panel stage 5 may absorb the substrate 2 and may absorb a large substrate.

The panel stage 5 may be formed long in the left-right direction X. The panel stage 5 may be formed long in the front-back direction Y. The left-right direction X length of the panel stage 5 may be longer than the front-back direction Y length of the panel stage 5. The panel stage 5 may have a rectangular shape that is elongated in the left-right direction X when viewed from above.

The donor loader 6 may load the donor 1. The donor loader 6 may load the donor 1 to the transfer head 7.

The donor loader 6 may be placed on the panel stage 5, and the donor loader 6 may be eccentrically placed on one side (for example, the right side) of the left and right sides of the panel stage 6. The donor loader 6 may be spaced apart from the substrate chuck 11 and the donor unloader 9 in the left-right direction X.

The donor loader 6 may include a reverser that may reverse the donor 1. The donor loader 6 may include a rotating device that may rotate the donor 1. The donor loader 6 may reverse and rotate the donor 1.

The donor loader 6 may include a barcode recognition unit that recognizes a barcode formed on the donor 1, and may recognize the barcode while tracking the donor 1. The donor loader 6 may align the position of the donor 1. The donor loader 6 may align the donor 1 prior to the transfer head 7 adsorbing the donor 1.

The donor 1 may be adsorbed on an adsorption plate 30' (Vacuum plate) as shown in a of FIG. 3, and may be sensed by a vision sensor 20'. The vision sensor may perform a pre-vision align that senses the **LED** chip 3 provided on the bottom surface of the donor 1 and the donor 1.

As shown in (a) of FIG. 3, the suction plate 30' may be the suction plate 30 of the transfer head 7, or may be provided separately from the suction plate 30 of the transfer head 7.

As shown in (a) of FIG. 3, a vision sensor 26' may be a vision sensor 26 arranged on the lower side of the substrate chuck 11, or may be provided separately from the vision sensor 26 arranged on the lower side of the substrate chuck 11.

The transfer head 7 may transfer the LED chip 3 provided on the donor 1 to the substrate 2.

After receiving the donor 1 of the donor loader 6, the transfer head 7 may transfer the LED chip 3 to the substrate 2.

The transfer head 7 may absorb the donor 1 and lift and lower the absorbed donor 1. The transfer head 7 may be movably arranged on the panel stage 5. The transfer head 7 may be arranged to move in the left-right direction X on the panel stage 5.

The transfer head 7 may correct the parallelism between the donor 1 and the substrate 2. The transfer head 7 may be controlled in the Z-axis (up-down direction) for each bonding section.

The transfer head 7 may be moved to the upper side of the donor loader 6 and may be moved to the upper side of the substrate chuck 11.

The transfer head 7 may move the donor 1 to the upper position of the substrate 2, as shown in (b) of FIG. 3, and may lower the donor 1 to the substrate 2 from the upper position of the substrate 2. The transfer head 7 may adjust the angle of the donor 1, and the donor 1 may be adjusted to be parallel to the substrate 2.

A plurality of transfer heads 7 may be provided. The plurality of transfer heads 7 may be arranged in a row. The plurality of transfer heads 7 may be arranged in a row in the front-back direction Y.

The apparatus for manufacturing a micro-LED display may include a transfer head mounter on which the plurality of transfer heads 7 is mounted, and the plurality of transfer heads 7 may be arranged in a row in the front-back direction Y on the transfer head mounter.

The apparatus for manufacturing a micro-LED display may further include a transfer head mounter moving mechanism that moves the transfer head mounter in the left-right direction X. The transfer head mounter moving mechanism may be mounted on the panel stage 2. The transfer head mounter moving mechanism may include a driving source such as a motor, and at least one power transmission member connected to the driving source and the transfer head mounter. The transfer head mounter moving mechanism may include a linear guide that guides the power transmission member.

The detaching head 8 may detach the donor 1 on which the LED chip 3 is transferred to the substrate 2. The detaching head 8 may remove the donor 1 from which the LED chip 3 is separated (i.e., transfer is completed). The detaching head 8 may remove the donor 1 from which the LED chip 3 is separated (i.e., transfer is completed) by adsorbing/gripping the donor 1. The detaching head 8 may transport the donor 1 located on the upper side of the substrate 2 to the donor unloader 9.

The detaching head 8 may be movably arranged on the panel stage 5. The transfer head 7 may be arranged to move in the left-right direction X on the panel stage 5.

The detaching head 8 may be moved to the upper side of the donor unloader 9. The detaching head 8 may transfer the donor 1 on the upper side of the substrate chuck 11 to the donor unloader 9.

A plurality of detaching heads 8 may be provided. The plurality of detaching heads 8 may be arranged in a row. The plurality of detaching heads 8 may be arranged in a row in the front-back direction Y.

The apparatus for manufacturing a micro-LED display may include a detaching head mounter on which the plurality of detaching heads 8 is mounted, and the plurality of detaching heads 8 may be arranged in a row in the front-back direction Y on the detaching head mounter.

The apparatus for manufacturing a micro-LED display may further include a detaching head mounter moving mechanism that moves the detaching head mounter in the left-right direction X. The detaching head mounter moving mechanism may be mounted on the panel stage 2. The detaching head mounter moving mechanism may include a driving source such as a motor, and at least one power transmission member connected to the driving source and the detaching head mounter. The detaching head mounter moving mechanism may include a linear guide that guides the power transmission member.

The donor unloader 9 may unload the donor 1.

The donor unloader 9 may be placed on the panel stage 5, and the donor unloader 9 may be eccentrically placed on the other side for example, the left side of the panel stage 6. The donor unloader 9 may be spaced apart from the substrate chuck 11 and the donor unloader 9 in the left-right direction X.

The donor unloader 9 may align the donor 1. The donor unloader 9 may include a reverser that may reverse the donor 1. The donor unloader 9 may include a rotation device that may rotate the donor 1. The donor unloader 9 may reverse and rotate the donor 1.

The apparatus for manufacturing a micro-LED display may include a vision sensor 20 (see (b) of FIG. 3) placed under the substrate chuck 11.

The vision sensor 26 may capture an image of the substrate 2 and an image of the LED chip 3 at a lower position of the substrate 2 mounted on the substrate chuck 11. The vision sensor 26 may capture an image of the LED chip 3 located on the lower surface of the donor 1 through an area opening or transparent portion of the substrate chuck 11 through which light may pass, and may capture the panel 2.

The apparatus for manufacturing a micro-LED display may correct the position of the LED chip 3, the angle of the donor 1, or the position of the substrate 2 according to the sensing result of the vision sensor 26, and may transfer the LED chip 3 to the correct position on the substrate 2.

The apparatus for manufacturing a micro-LED display may be positioned on the upper side of the substrate 2 as shown in (b) of FIG. 3 after the substrate 2 is placed on the substrate chuck 11 of the panel stage 5 as shown in FIG. 1 and FIG. 2. Thereafter, the donor 1 may be lowered to the substrate 2 as shown in (c) of FIG. 3 to transfer the LED chip 3 to the substrate 2, especially the adhesive 2b, and the LED chip 3 may be adhered to the substrate 2 by the adhesive 2b, as shown in (d) of FIG. 3. Thereafter, the donor 1 may be raised away from the substrate 2 as shown in (e) of FIG. 3 and may be removed from the substrate 2.

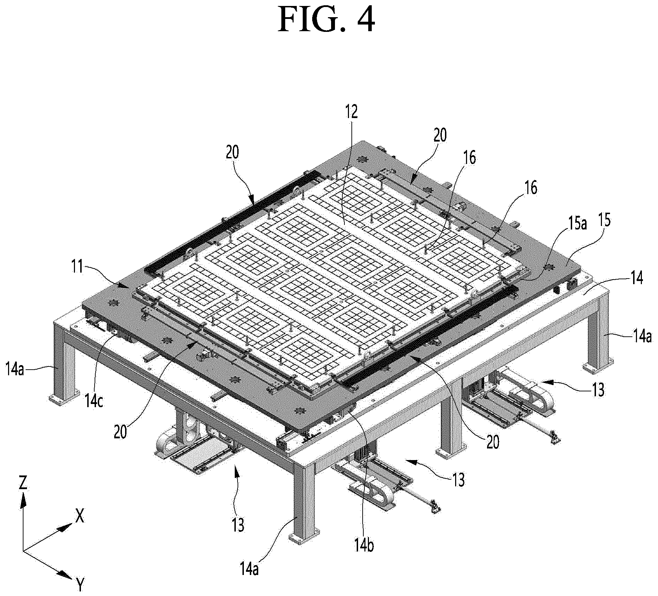

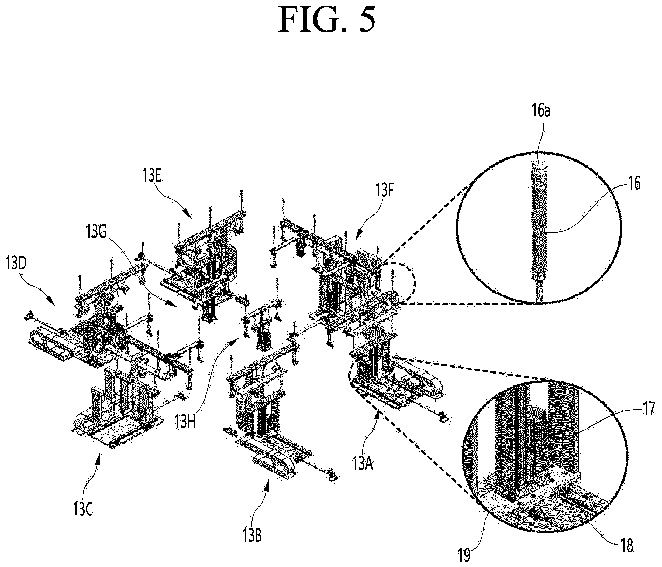

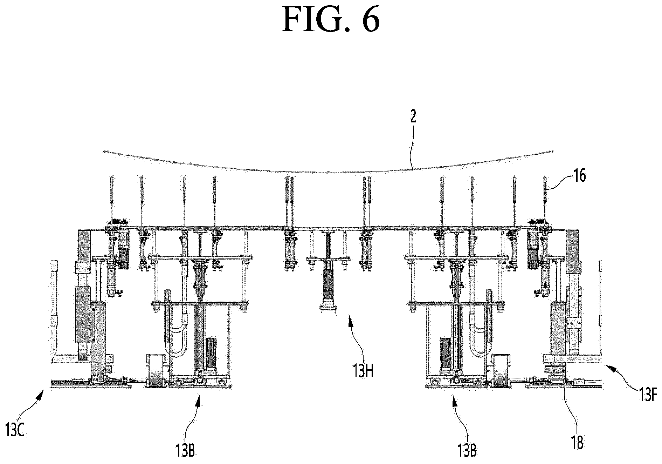

FIG. 4 is a perspective view of a panel stage according to the present embodiment. FIG. 5 is a perspective view of a panel pop-up mechanism according to the present embodiment, and FIG. 6 is a front view of the panel pop-up mechanism according to the present embodiment when the substrate is bent.

The substrate chuck 11 may include a panel chuck 12 and a panel pop-up mechanism 13, as shown in FIG. 4.

The panel stage 5 may further include a table 14 having legs 14a, as shown in FIG. 4, and the substrate chuck 11 may be placed on the table 14.

The substrate chuck 11 may further include a mounting member 15 and a transfer mechanism 14b and 14c.

The mounting member 15 may be placed on the table 14, and a panel chuck mounting portion 15a on which the panel chuck 12 is mounted may be formed on the mounting member 15. The panel chuck mounting portion 15a may be formed to protrude from the upper surface of the mounting member 15. The panel chuck mounting portion 15a may have an opening or transparent portion formed in the center. The panel chuck 12 may be mounted on the panel chuck mounting portion 15a in an area close to the edge.

The mounting member 15 may be arranged to be horizontally movable on the table 14. The transfer mechanism 14b and 14c such as a motor for moving the mounting member 15 may be mounted on the table 14. The transfer mechanism 14b and 14c such as a motor may include a left-right transfer mechanism that may move the mounting member 15 in the left-right direction X. The transfer mechanism 14b and 14c such as a motor may include a back-and-forth transfer mechanism that may move the mounting member 15 in the front-back direction Y.

The panel chuck 12 may be mounted on the panel chuck mounting portion 15a and supported on the mounting member 15. The panel chuck 12 may be placed on the table 14.

A plurality of suction holes may be formed on the panel chuck 12. The panel chuck 12 may be a vacuum plate that absorbs the substrate 2.

A suction tube may be connected to the panel chuck 12. The suction tube may be connected to the suction hole of the panel chuck 12 and the suction device. The substrate 2 placed on the upper surface of the panel chuck 12 may be absorbed by the panel chuck 12 by the suction tube and the suction device.

The panel chuck 12 may be divided into multiple regions. A plurality of suction holes may be formed in each of the multiple regions. An example of the multiple regions may be 12 regions. The panel chuck 12 may flatly adsorb or air-float the substrate 2.

The panel chuck 12 may be positioned above the vision sensor 26 and may cover the vision sensor 26 from the upper side.

The panel chuck 12 may be formed of a ceramic series material or a reinforced glass material. An example of the panel chuck 12 may be a Pyrex material. The panel chuck 12 may be transparent or translucent.

It is preferable that the panel chuck 12 satisfies the transparency condition that allows the precision vision of the vision sensor 26 to pass through. The panel chuck 12 is applied with a Pyrex material, and the upper surface of the Pyrex may be polished.

Meanwhile, a pin through hole through which a pin 16 of the panel pop-up mechanism 13 penetrates may be formed in the panel chuck 12. The pin through hole may be spaced apart from the suction hole that suctions the substrate 2.

The panel pop-up mechanism 13 may be a mechanism that may elevate or bend the substrate 2 mounted on the panel chuck 12.

The panel pop-up mechanism 13 may include the pin 16, as shown in FIGS. 4 to 6. The pin 16 may be positioned so as to be liftable on the panel chuck 12. The pin 16 may protrude upwardly from the panel chuck 12 through the pin through hole of the panel chuck 12 and may be lowered into the pin through hole of the panel chuck 12. This pin 16 may elevate the substrate 2 positioned on the panel chuck 12.

An upper end 16a of the pin 16 may be curved. The upper end 16a of the pin 16 may be a contact surface that comes into contact with the substrate 2, and when the upper end 16a of the pin 16 is curved, the contact area between the substrate 2 and the pin 16 may be minimized.

The panel pop-up mechanism 13 may include a driving source 17 such as a motor or cylinder that raises and lowers the pin 16. The driving source 17 may be configured as a servo motor that raises and lowers the pin 16, and may control the pin 16 in the Z-axis servo. The driving source 17 and the pin 16 may be connected by a power transmission member.

The power transmission member may convert the rotational motion of the driving source 17 into the up-and-down linear motion of the pin 16, and may include a gear, a link, a screw, a belt, or the like. The power transmission member is not limited to the type as long as it may convert the rotational motion of the driving source 17 into the up-and-down linear motion of the pin 16.

The panel pop-up mechanism 13 may include a pop-up base 18. The pop-up base 18 may support the panel pop-up mechanism 13. The pop-up base 18 may be placed on the ground.

A pop-up frame 19 may be placed on the pop-up base 18. The pop-up frame 19 may be a combination of multiple members.

The panel pop-up mechanism 13 may include a plurality of pins 16 and a plurality of driving sources 17.

The panel pop-up mechanism 13 may include a plurality of pop-up units 13A, 13B, 13C, 13D, 13E, 13F, 13G, and 13H including the pin 16 and the driving source 17.

When the eight pop-up units 13A, 13B, 13C, 13D, 13E, 13F, 13G, and 13H are provided, the panel pop-up mechanism 13 may lift and lower eight areas of the substrate 2 differently.

The plurality of pop-up units 13A, 13B, 13C, 13D, 13E, 13F, 13G, and 13H may control multiple pop-up units 13A, 13B, 13C, 13D, 13E, 13F, 13G, and 13H so that the upper height of some of the multiple pins 16 is different from the upper height of the remaining pins 16.

The plurality of pop-up units 13A, 13B, 13C, 13D, 13E, 13F, 13G, and 13H may include outer pop-up units 13A, 13B, 13C, 13D, 13E, and 13F that include the pin 16a that contacts an area close to the edge of the substrate 2, and inner pop-up units 13G and 13H that include the pin 16a that contacts an area close to the center of the substrate 2.

The pin 16 elevation height of the inner pop-up units 13G and 13H may be lower than the pin 16 elevation height of the outer pop-up units 13A, 13B, 13C, 13D, 13E, and 13F. In this case, the substrate 2 may be supported in a shape in which the height of the edge is higher than the height of the center, and the substrate 2 may be bent in a shape close to a U-shape.

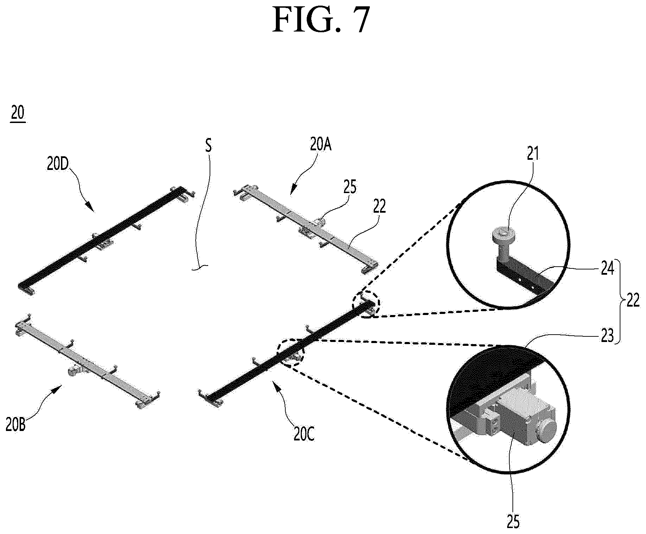

FIG. 7 is a perspective view of an aligner according to the present embodiment.

The substrate chuck 11 may further include an aligner 20 for aligning the substrate 2. The aligner 20 may be provided in multiple numbers on the panel chuck 12.

The plurality of aligners 20 may be arranged around the panel chuck 12, as shown in FIG. 4.

The plurality of aligners 20 may include a left aligner 20A and a right aligner 20B spaced apart in the left-right direction X and may include a front aligner 20C and a rear aligner 20D spaced apart in the front-back direction Y.

The plurality of aligners 20 may be spaced apart from each other. A panel chuck receiving space S in which the panel chuck 12 is received may be formed between the left aligner 20A, the right aligner 20B, the front aligner 20C, and the rear aligner 20D.

The aligner 20 may include a urethane roller 21, a link 22 on which the urethane roller 21 is arranged, and a motor 25 that operates the link 22.

The outer peripheral surface of the urethane roller 21 may be in contact with the peripheral surface of the substrate 2 or the peripheral surface of the panel chuck 12.

The link 22 may include a main link 23 arranged along the periphery of the panel chuck 12, and a plurality of sub-links 24 arranged on the main link 23 and facing the periphery of the panel chuck 12.

The urethane roller 21 may be rotatably mounted on the sub-link 24. The urethane roller 21 may be spaced apart from the main roller 23.

An example of the motor 25 may be a servo motor and may be servo controlled. The motor 25 may rotate or linearly move the link 22.

Each of the substrate 2 and the panel chuck 12 may include four peripheries left periphery, right periphery, front periphery, rear periphery. The urethane roller 21 of each of the plurality of aligners 20 may be in contact with the circumference of the substrate 2 or the circumference of the panel chuck 12.

When the plurality of aligners 20 include the urethane roller 21, when the substrate 2 is aligned by the plurality of aligners 20, damage to the substrate 2 made of glass may be minimized.

The plurality of aligners 20 may align four circumferential surfaces with respect to the mounting position of the substrate 2, and the substrate 2 may be individually aligned on four surfaces, and the alignment position may be adjusted by servo control.

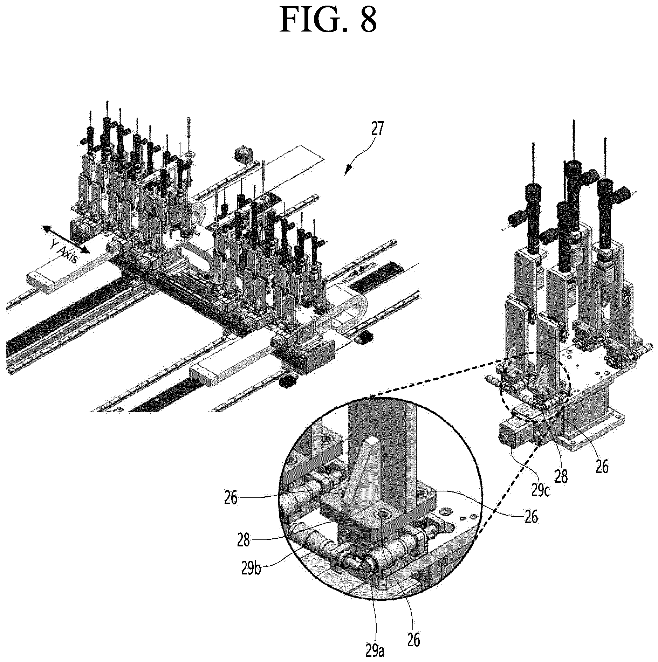

FIG. 8 is a perspective view illustrating a panel vision alignment mechanism according to the present embodiment.

The apparatus for manufacturing a micro-LED display may include a panel vision alignment mechanism 27 including a vision sensor 26.

The vision alignment mechanism 27 may simultaneously photograph the alignment key of the substrate 2 and the alignment key of the donor 1 from the lower portion of the substrate 2, and the apparatus for manufacturing a micro-LED display may simultaneously correct the donor 1 and the substrate 2.

The vision sensor 26 may include a high-resolution camera sensor, and may be adjusted to a right angle of within 5 µm.

The vision alignment mechanism 27 may include four high-resolution camera sensors as a set, and may be configured to individually drive one set of the four high-resolution camera sensors in the X-axis, Y-axis, and Z-axis.

The vision alignment mechanism 27 may include a vision sensor mounter 28 having the vision sensor 26 installed therein, and may include an X-axis driving unit 29a capable of driving the vision sensor mounter 28 along the X-axis, a Y-axis driving unit 29b capable of driving the vision sensor mounter 28 along the Y-axis, and a Z-axis driving unit 29c capable of driving the vision sensor mounter 28 along the Z-axis.

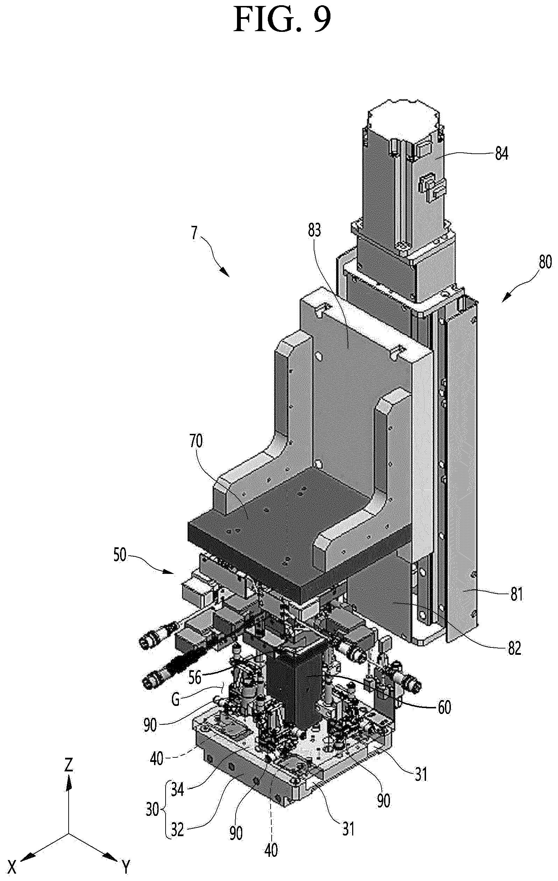

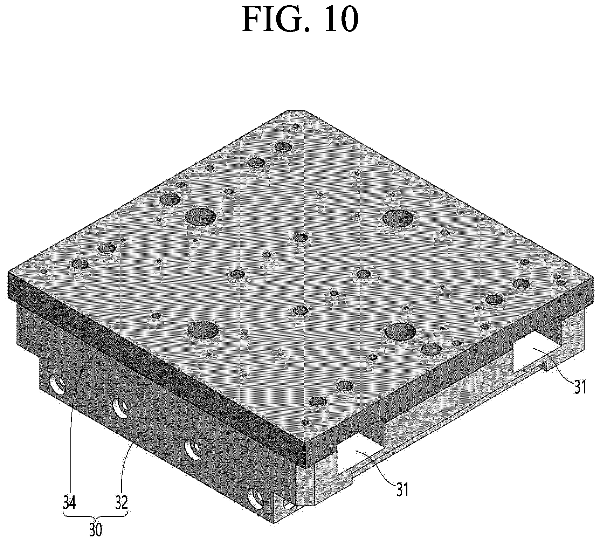

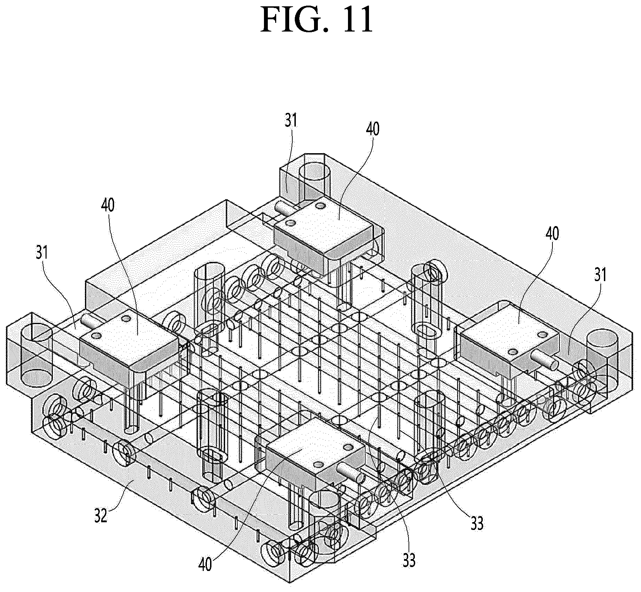

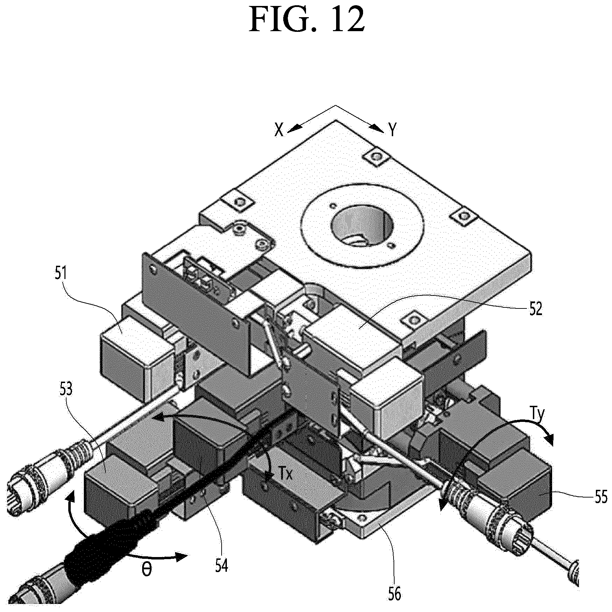

FIG. 9 is a perspective view of a transfer head according to the present embodiment, FIG. 10 is a perspective view illustrating an adsorption plate of a transfer head according to the present embodiment, FIG. 11 is a perspective view illustrating an adsorption plate and a light source of a transfer head according to the present embodiment, and FIG. 12 is a perspective view illustrating a drive module of a transfer head according to the present embodiment.

The transfer head 7 may include a suction plate 30 to which the donor 1 is sucked.

A light source 40 that irradiates light toward the donor 1 may be placed on the suction plate 30.

A light source receiving portion 31 in which a light source 40 is inserted and received may be formed on the suction plate 30.

The suction plate 30 may be a combination of multiple members, and the suction plate 30 may include a suction plate 32 and a fixed plate 34. The suction plate 30 may have an overall hexahedral shape.

The suction plate 32 may have a plurality of suction holes 33 (see FIG. 11). The suction holes 33 may be formed through the suction plate 32. The upper surface of the donor 1 may be absorbed by the lower surface of the suction plate 32.

It is preferable that the suction hole 33 has a diameter capable of absorbing the donor 1.

It is preferable that the suction plate 32 itself be configured to ensure the flatness of the donor 1 when absorbing the donor 1. An example of the diameter of the suction hole 33 may be 0.7 mm. The suction plate 32 may be a vacuum plate in which a plurality of suction holes 33 having a diameter of 0.7 mm are formed.

The light source receiving portion 31 may be formed in the suction plate 32. The light source receiving portion 31 may be formed in a sunken shape in the suction plate 32, as illustrated in FIG. 11. The light source receiving portion 31 may be in the form of an upper surface and a side surface open to the suction plate 32. A plurality of light source receiving portions 31 may be formed on the suction plate 32, and the plurality of light source receiving portions 31 may be formed to be spaced apart from each other.

The light source receiving portion 31 may be formed to be spaced apart from the suction hole 33.

The suction plate 32 is configured to have a structure in which light generated from the light source 40 may be irradiated downward, and the suction plate 32 may have an opening formed on the lower side of the light source receiving portion 31 through which light is transmitted, or a transparent portion may be arranged.

The light source 40 may be configured as a white back light that allows the vision sensor 26 to simultaneously recognize the alignment key of the substrate 2 and the alignment key of the donor 1.

If the light source 40 is not located below the substrate chuck 11 but above the donor 1, the light source 40 may be closer to the donor 1, and the vision sensor 26 may sense the alignment key of the donor 1 and the alignment key of the substrate 2 with greater reliability.

A plurality of light sources 40 may be provided on the suction plate 32. It is preferable that at least four light sources 40 are provided.

The fixed plate 34 may be placed on the upper surface of the suction plate 32, as shown in FIG. 10. The fixed plate 34 may cover the upper surface of the suction plate 32. The fixed plate 34 may be fastened to the suction plate 32 with a fastening member such as a screw.

The fixed plate 34 may cover the light source receiving portion 31. The light source 40 may be hidden by the fixed plate 34.

The fixed plate 34 may be connected to the connecting bracket 60 (see FIG. 9) of the transfer head 7.

The transfer head 7 may further include a driving module 50, a connecting bracket 60, a lifting plate 70, and a lifting mechanism 80, as shown in FIG. 9.

The driving module 50 may be arranged on the upper side of the connecting bracket 60 and may be connected to the connecting bracket 60. An output shaft 56 of the driving module 50 may be connected to the connecting bracket 60.

The driving module 50 may have an X-axis driving source 51, a Y-axis driving source 52, a θ-axis driving source 53, a Tx-axis driving source 54, and a Ty-axis driving source 55, as shown in FIG. 12. The driving module 50 may be a 5-axis module capable of moving and rotating the connecting bracket 60 along 5 axes. The drive module 50 may move the output shaft 56 along the X-axis, Y-axis, and rotate the Tx-axis, Ty-axis, and θ-axis.

The X-axis movement may be the left-right direction X movement of the output shaft 56, and the Y-axis movement may be the front-back direction Y movement.

The θ-axis rotation may be the rotation around the vertical first center axis of the output shaft 56.

The Tx-axis rotation may be the rotation of the output shaft 56 around the horizontal second center axis, but the second center axis may be the center axis of the left-right direction X.

The Ty-axis rotation may be the rotation of the output shaft 56 around the horizontal third center axis, but the third center axis may be the center axis of the front-back direction Y.

As shown in FIG. 9, the driving module 50 may be spaced apart from the suction plate 50 in the upper side of the suction plate 30 in the up-down direction Z, and a gap G may be formed between the suction plate 30 and the driving module 50.

The upper part of the connecting bracket 60 may be connected to the driving module 50, and the lower part may be connected to the suction plate 30. The connecting bracket 60 may be long in the vertical direction, and the driving module 50 and the suction plate 30 may be spaced apart from each other in the vertical direction by the connecting bracket 60.

The upper part of the connecting bracket 60 may be connected to the output shaft 56 of the driving module 50. The lower part of the connecting bracket 60 may be connected to the fixed plate 34.

The lifting plate 70 may be placed on the upper part of the driving module 50. The driving module 50 may be installed on the lifting plate 70 so as to be hung on the lifting plate 70. The size of the lifting plate 70 may be larger than the size of the driving module 50, and the driving module 50 may be protected by the lifting plate 70.

The lifting mechanism 80 may be a Z-axis mover that may move the driving module 50 in the Z-axis direction.

The lifting mechanism 80 may be connected to the lifting plate 70 and may elevate the lifting plate 70. The lifting mechanism 80 is not limited to its type as long as it has a configuration that may lift the lifting plate 70.

An example of the lifting mechanism 80 may include a lifting guide 81, a lifting plate 82 guided by the lifting guide 81, a connecting member 83 connecting the lifting plate 82 and the lifting plate 70, and a lifting driving source 84 that generates a driving force to lift the lifting plate 82.

The lifting guide 81 may be an **LM** guide formed long in the vertical direction.

The lifting guide 81 may be mounted on a transfer head mounter.

An example of the lifting driving source 84 may be a servo motor.

The transfer head 7 may further include a displacement sensor 90. The displacement sensor 90 may calculate the height or inclination between the substrate 2 and the donor 1.

An example of the displacement sensor 90 may be a laser displacement sensor, and a spectral sensor with a resolution of 0.25 µm may be applied to the laser displacement sensor. The displacement sensor 90 may have a manual stage structure that allows precise adjustment for the X-axis, Y-axis, and Z-axis.

The displacement sensor 90 may irradiate a laser to the donor 1 or the substrate 2 through the opening of the suction plate 30 from the upper side of the suction plate 30, and may sense the distance between the donor 1 and the substrate 2 or the degree of inclination of the donor 1 or the substrate 2.

The displacement sensor 90 may be accommodated in the gap G between the suction plate 30 and the driving module 50, and may be protected by the suction plate 30 and the driving module 50.

The displacement sensor 90 may be positioned around the connecting bracket 60, and a plurality of displacement sensors 90 may be arranged around the connecting bracket 60. A plurality of displacement sensors 90 may be arranged spaced apart from each other around the connecting bracket 60.

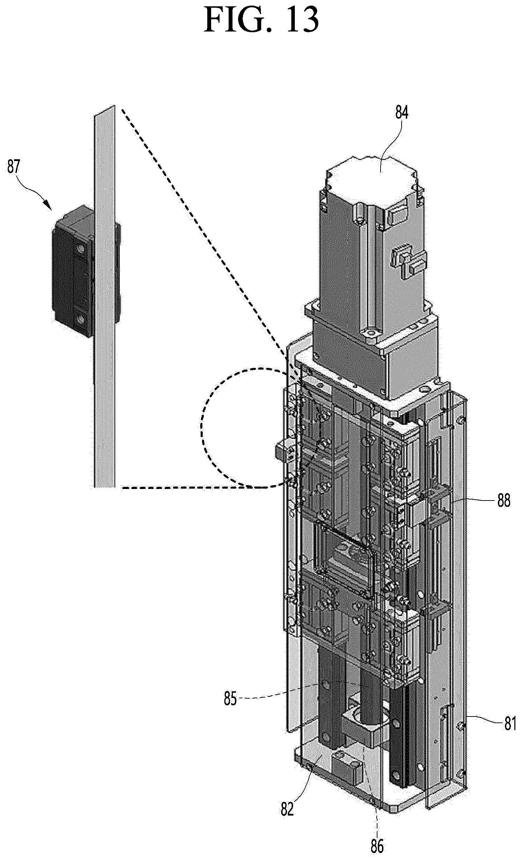

FIG. 13 is a perspective view illustrating a lifting mechanism of a transfer head according to the present embodiment.

The lifting mechanism 80 of the transfer head 7 may further include a screw 85 and a lifting connector 86.

The screw 85 may be connected to a lifting drive source 84. The screw 85 may be formed to be long in the up-down direction Z and may be connected to a rotational axis of the lifting drive source 84.

The lifting connector 86 may be lifted along the screw 85 and connected to the lifting plate 82.

When the lifting drive source 84 is driven, if the screw 85 rotates, the lifting connector 86 may be lifted along the outer circumference of the screw 85.

The lifting mechanism 80 of the transfer head 7 may further include an encoder scale 87.

The encoder scale 87 may be a scale of a full closed control method to control within 0.1 µm through a precision scale, and may be precisely driven in the Z-axis direction of the suction plate 30.

The lifting mechanism 80 of the transfer head 7 may further include a photo sensor 88. The photo sensor 88 may sense the lifting plate 82, and the apparatus for manufacturing a micro-LED display may control the lifting height of the lifting plate 82.

The above description is merely an example of the technical idea of the present disclosure, and those with ordinary knowledge in the technical field to which the present disclosure belongs may make various modifications and variations without departing from the essential characteristics of the present disclosure.

Therefore, the embodiments disclosed in the present disclosure are not intended to limit the technical idea of the present disclosure, but to explain it, and the scope of the technical idea of the present disclosure is not limited by these embodiments.

The protection scope of the present disclosure should be interpreted by the claims below, and all technical ideas within the equivalent scope should be interpreted as being included in the scope of the rights of the present disclosure.

## Claims

1. An apparatus for manufacturing a micro-LED display, comprising:
a substrate chuck on which a substrate is mounted;
a transfer head having an adsorption plate on which a donor is adsorbed, transferring an LED chip transferred to the donor to the substrate; and
a vision sensor disposed below the substrate chuck,
wherein a light source irradiating light toward the donor is disposed on the adsorption plate.

2. The apparatus according to claim 1, wherein the substrate chuck includes:
a panel chuck having a plurality of suction holes formed therein;
a pin disposed to be liftable on the panel chuck and lifting the substrate; and
a plurality of aligners for aligning the substrate.

3. The apparatus according to claim 1, wherein the panel chuck is disposed above the vision sensor, and
wherein the panel chuck is made of a Pyrex material.

4. The apparatus according to claim 1, wherein the pin has a curved upper surface.

5. The apparatus according to claim 1, wherein the plurality of aligners includes:
a left aligner and a right aligner spaced apart in a left-right direction; and
a front-side aligner and a right-side aligner spaced apart in a front-back direction.

6. The apparatus according to claim 2, wherein the aligner includes:
a urethane roller;
a link on which the urethane roller is arranged; and
a motor for driving the link.

7. The apparatus according to claim 1, wherein the suction plate is formed with a light source receiving portion into which the light source is inserted and received.

8. The apparatus according to claim 7, wherein the suction plate includes:
a suction plate having a plurality of suction holes and in which the light source receiving portion is formed spaced apart from the suction hole; and
a fixing plate arranged on the upper surface of the suction plate and covering the light source receiving portion.

9. The apparatus according to claim 1, wherein the transfer head further includes:
a driving module;
a connecting bracket connected to the driving module and having a lower portion connected to the suction plate;
a lifting plate arranged on the upper portion of the driving module; and
a lifting mechanism for lifting the lifting plate.

10. The apparatus according to claim 1, wherein the driving module has a X-axis driving source, a Y-axis driving source, a Θ-axis driving source, a Tx-axis driving source, and a Ty-axis driving source, and is a 5-axis module that moves the connecting bracket along the X-axis and Y-axis and rotates connecting bracket along the Tx-axis, Ty-axis, and Θ-axis.

11. The apparatus according to claim 1, wherein the transfer head further includes a displacement sensor for calculating a height or inclination between the substrate and the donor.

12. The apparatus according to claim 11, wherein a gap is formed between the suction plate and the driving module, and
wherein the displacement sensor is received in the gap.
